# EUROPEAN PATENT APPLICATION

(11) **EP 4 529 371 A1**
(43) Date of publication of application: **26.03.2025**
(21) Application number: 22942654.9
(22) Date of filing: 18.05.2022
(51) Int. Cl.: H05K 7/14

(54) **CIRCUIT CONNECTION DEVICE AND ROTATING ELECTRICAL MACHINE DEVICE**

(71) Applicant: MITSUBISHI ELECTRIC CORPORATION, Chiyoda-ku Tokyo 100-8310 (JP)
(72) Inventor: TAKESHIMA, Kenta, Tokyo 100-8310 (JP); FUNABIKI, Yusuke, Tokyo 100-8310 (JP); SONODA, Isao, Tokyo 100-8310 (JP)
(74) Representative: Hoffmann Eitle
(86) International application number: PCT/JP2022/020622
(87) International publication number: WO 2023/223449

(57) **Abstract**

A circuit connection device includes a connector including a connection terminal connected to an outside; a circuit board on which an electronic component is mounted and in which a terminal hole into which the connection terminal is press-fitted is formed; a board support member that supports the circuit board; and a fixing member that fixes the circuit board to the board support member. The circuit board includes a mounting portion on which the electronic component is mounted, and a supported portion fixed to the board support member by the fixing member and supported by the board support member. The supported portion is disposed between the mounting portion and the terminal hole.

## Description

### [Technical Field]

The present disclosure relates to a circuit connection device and a rotating electrical machine device.

### [Background Art]

In the related art, as a control unit for a rotating electrical machine device, a circuit connection device including a circuit board on which electronic components are mounted and a connector including connection terminals connected to the outside is used. For example, when press-fit terminals are used as the connection terminals, electrical connection between the circuit board and the connector can be ensured by press-fitting the press-fit terminals into terminal holes formed in the circuit board without performing soldering or the like.

### [Citation List]

### [Patent Document]

[Patent Document 1]
PCT International Publication No. WO 2021/161947

### [Summary of Invention]

### [PROBLEM TO BE SOLVED BY THE INVENTION]

When the connection terminals are press-fitted into the terminal holes, a pressing force is applied to the circuit board. In recent years, the number of the connection terminals of the connector has been increased, for example, for redundancy of the rotating electrical machine device. In this case, the pressing force applied to the circuit board when the connection terminals are press-fitted into the terminal holes is increased. In the structure of Patent Document 1, there is a possibility that a distortion may occur in the circuit board due to a pressing force applied to the circuit board and the electronic components mounted on the circuit board may be damaged.

Patent Document 1 also discloses a structure in which a control unit includes a parent board on which the electronic components are mounted and a child board to which the connection terminals are connected. However, in this case, the number of components of the rotating electrical machine device is increased.

The present disclosure has been made to solve the above-described problems, and an object of the present disclosure is to provide a circuit connection device and a rotating electrical machine device capable of suppressing the distortion of a circuit board and preventing damage to an electronic component mounted on the circuit board while suppressing an increase in the number of components.

### [MEANS TO SOLVE THE PROBLEM]

A circuit connection device according to the present disclosure includes a connector including a connection terminal connected to an outside, a circuit board on which an electronic component is mounted and in which a terminal hole into which the connection terminal is press-fitted is formed, a board support member that supports the circuit board, and a fixing member that fixes the circuit board to the board support member, in which the circuit board includes a mounting portion on which the electronic component is mounted, and a supported portion fixed to the board support member by the fixing member and supported by the board support member, and the supported portion is disposed between the mounting portion and the terminal hole.

A rotating electrical machine device according to the present disclosure includes a rotating electrical machine, and the circuit connection device configured to control the rotating electrical machine.

### [EFFECTS OF THE INVENTION]

According to the present disclosure, it is possible to provide the circuit connection device and the rotating electrical machine device capable of suppressing the distortion of the circuit board and preventing damage to the electronic component mounted on the circuit board while suppressing an increase in the number of components.

### [Brief Description of Drawings]

FIG. 1 is a schematic cross-sectional view of a rotating electrical machine device according to a first embodiment.
FIG. 2 is a perspective view of a circuit connection device according to the first embodiment.
FIG. 3A is a perspective view of a circuit board according to the first embodiment.
FIG. 3B is a perspective view of the circuit board according to the first embodiment.
FIG. 4 is a perspective view of a connector according to the first embodiment.
FIG. 5 is a perspective view of a board support member according to the first embodiment.
FIG. 6 is a perspective view of the circuit board and the board support member according to the first embodiment.
FIG. 7A is a view showing a schematic configuration of the circuit connection device according to the first embodiment.
FIG. 7B is a view showing the schematic configuration of the circuit connection device according to the first embodiment.
FIG. 8A is a view showing a schematic configuration of a circuit connection device according to a modification example of the first embodiment.
FIG. 8B is a view showing the schematic configuration of the circuit connection device according to the modification example of the first embodiment.
FIG. 9A is a view showing a schematic configuration of a circuit connection device according to another modification example of the first embodiment.
FIG. 9B is a view showing the schematic configuration of the circuit connection device according to the other modification example of the first embodiment.
FIG. 10 is a perspective view of a circuit connection device according to a second embodiment.
FIG. 11 is a perspective view of a circuit board and a board support member according to the second embodiment.
FIG. 12A is a view showing a schematic configuration of the circuit connection device according to the second embodiment.
FIG. 12B is a view showing the schematic configuration of the circuit connection device according to the second embodiment.
FIG. 13A is a view showing a schematic configuration of a circuit connection device according to a modification example of the second embodiment.
FIG. 13B is a view showing the schematic configuration of the circuit connection device according to the modification example of the second embodiment.
FIG. 14A is a view showing a schematic configuration of a circuit connection device according to a third embodiment.
FIG. 14B is a view showing the schematic configuration of the circuit connection device according to the third embodiment.
FIG. 15 is a view showing a schematic configuration of a circuit connection device according to a modification example of the third embodiment.
FIG. 16A is a view showing a schematic configuration of a circuit connection device according to a fourth embodiment.
FIG. 16B is a view showing the schematic configuration of the circuit connection device according to the fourth embodiment.
FIG. 17 is a view showing a schematic configuration of a circuit connection device according to a fifth embodiment.
FIG. 18 is a view showing a schematic configuration of a circuit connection device according to a modification example of the fifth embodiment.
FIG. 19A is a view showing a schematic configuration of a circuit connection device according to a sixth embodiment.
FIG. 19B is a view showing the schematic configuration of the circuit connection device according to the sixth embodiment.
FIG. 20A is a view showing a schematic configuration of a circuit connection device according to a comparative example of the first embodiment.
FIG. 20B is a view showing the schematic configuration of the circuit connection device according to the comparative example of the first embodiment.

### [Description of Embodiments]

### First embodiment

Hereinafter, a circuit connection device 2 and a rotating electrical machine device 100 according to a first embodiment will be described with reference to the drawings.

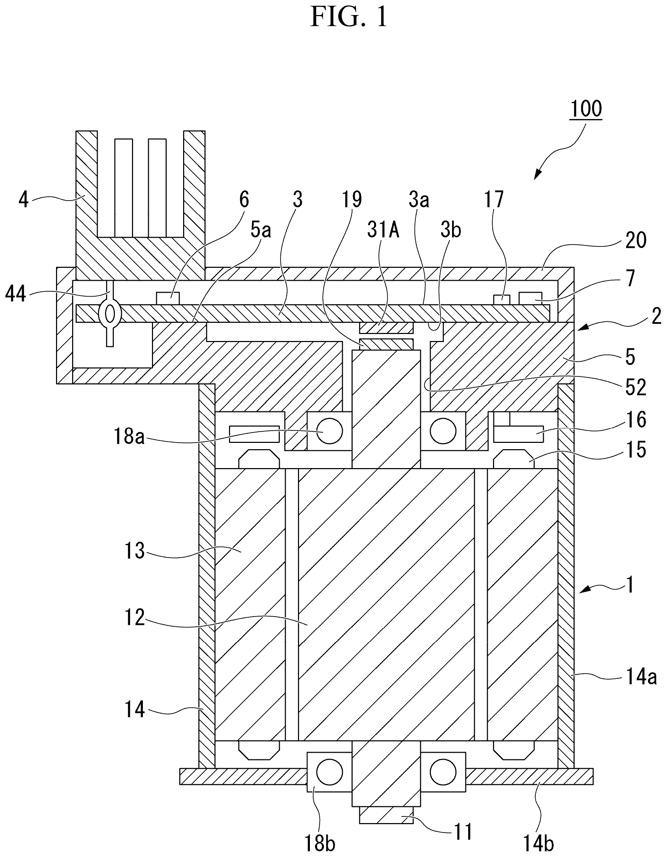

FIG. 1 is a schematic cross-sectional view of the rotating electrical machine device 100. The rotating electrical machine device 100 includes a rotating electrical machine 1 that is of a multiphase winding type, and the circuit connection device 2 that controls the rotating electrical machine 1.

The rotating electrical machine 1 mainly includes a rotating shaft 11, a rotor 12, a stator 13, a case 14, a winding 15, an annular wiring portion 16, a wiring terminal 17, and first and second bearings 18a and 18b.

FIG. 1 is a cross-sectional view of the rotating electrical machine device 100 taken along the rotating shaft 11. In FIG. 1, a lower side of the drawing sheet is an output side of the rotating shaft 11, and an upper side of the drawing sheet is a non-output side of the rotating shaft 11.

The rotating shaft 11 extends along an axis. The rotor 12 is fixed to the rotating shaft 11. A plurality of pairs of permanent magnets (not shown) are disposed on an outer peripheral surface of the rotor 12. These permanent magnets constitute field poles.

The stator 13 is provided to surround an outer periphery of the rotor 12. The stator 13 is fixed to an inner surface of the case 14. An air gap is formed between the outer peripheral surface of the rotor 12 and an inner peripheral surface of the stator 13. The air gap is formed over the entire circumference in a circumferential direction around the axis of the rotating shaft 11.

The case 14 accommodates the rotating shaft **11,** the rotor 12, and the stator 13. The case 14 includes a cylindrical portion 14a and a bottom portion 14b. The cylindrical portion 14a covers the stator 13 from an outer peripheral side. The stator 13 is fixed to the cylindrical portion 14a by press-fitting. The bottom portion 14b covers a lower end of the cylindrical portion 14a. An upper end of the cylindrical portion 14a is covered with a board support member 5 of the circuit connection device 2 to be described later.

The winding 15 is wound around the stator 13. The winding 15 includes a U-phase winding, a V-phase winding, and a W-phase winding.

The annular wiring portion 16 is disposed on the non-output side (namely, the upper side in FIG. 1) of the rotating shaft 11 with respect to the winding 15. The annular wiring portion 16 is connected to an end portion of the winding 15 by TIG welding or the like.

The wiring terminal 17 is connected to the annular wiring portion 16. The wiring terminal 17 extends from the annular wiring portion 16 through the board support member 5 to the non-output side of the rotating shaft 11. The wiring terminal 17 is electrically connected to the end portion of the winding 15 via the annular wiring portion 16. The wiring terminal 17 is composed of three conductors. The three conductors are respectively connected to a wiring terminal of the U-phase winding, a wiring terminal of the V-phase winding, and a wiring terminal of the W-phase winding of the winding 15.

The first bearing 18a is provided at an end portion on the non-output side of the rotating shaft 11. The first bearing 18a is fixed to the board support member 5. The second bearing 18b is provided at an end portion on the output side of the rotating shaft 11. The second bearing 18b is fixed to the bottom portion 14b. The first bearing 18a and the second bearing 18b rotatably support the rotating shaft 11.

A sensor rotor 19 is fixed to an end surface on the non-output side of the rotating shaft 11. The sensor rotor 19 rotates together with the rotating shaft 11. The sensor rotor 19 includes a pair of, or a plurality of pairs of permanent magnets.

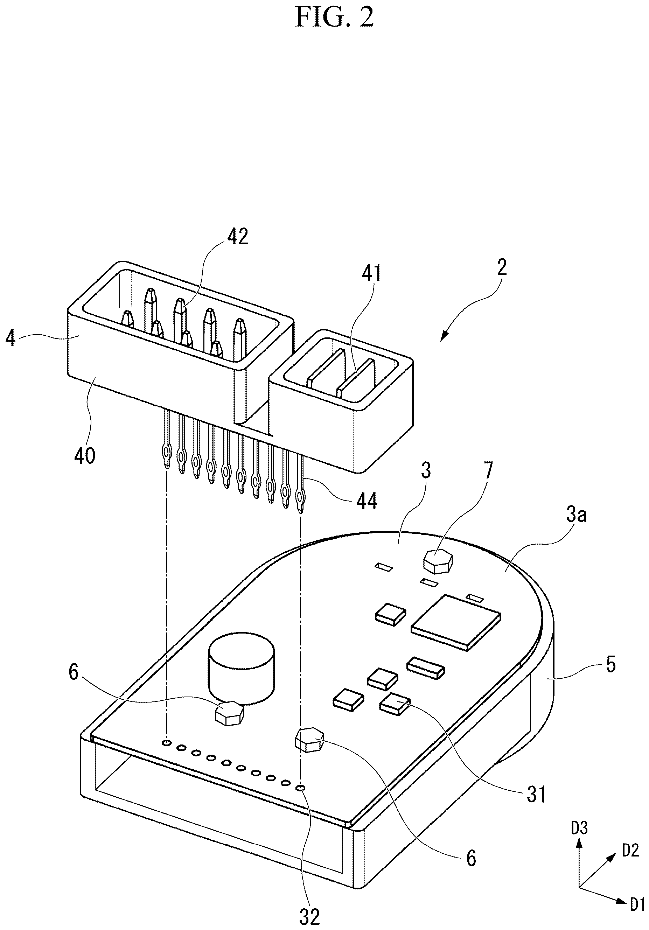

The circuit connection device 2 is a control unit that controls a current flowing through the winding 15 of the rotating electrical machine 1. The circuit connection device 2 includes a circuit board 3, a connector 4, the board support member 5, first fastening members 6 (fixing member), a second fastening member 7, and a cover 20. The cover 20 covers the circuit board 3 and the board support member 5. FIG. 2 is a perspective view of the circuit connection device 2, and is a view showing a state in which the cover 20 is removed.

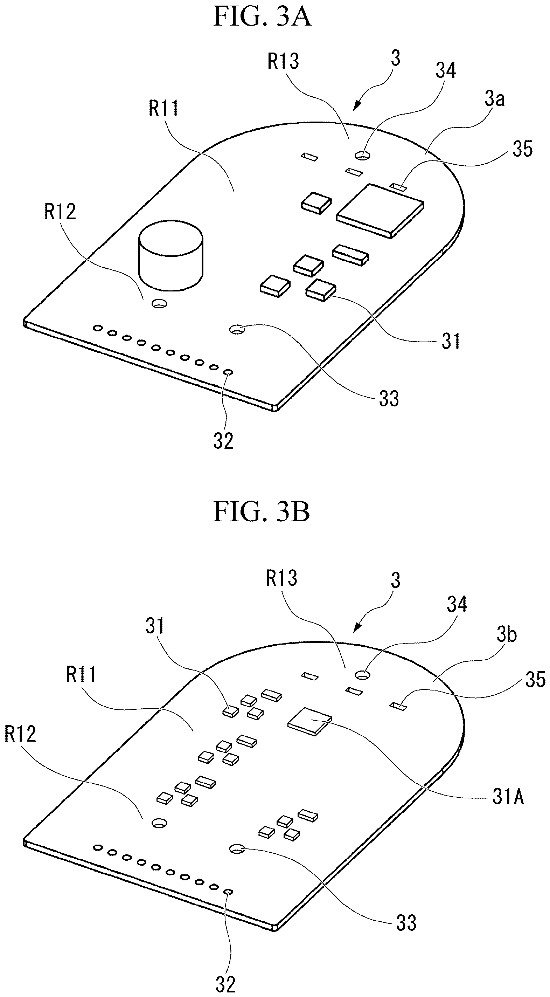

The circuit board 3 is a printed wiring board. As shown in FIG. 1, the circuit board 3 has a first surface 3a and a second surface 3b. FIG. 3A is a perspective view of the circuit board 3 when viewed from the first surface 3a side, and FIG. 3B is a perspective view of the circuit board 3 when viewed from the second surface 3b side.

Hereinafter, as shown in FIG. 2, one direction in a plane along the first surface 3a is referred to as a first direction D1, and a direction orthogonal to the first direction D1 in the plane is referred to as a second direction D2. In addition, a direction orthogonal to the first direction D1 and the second direction D2 is referred to as a third direction D3. The third direction D3 is a thickness direction of the circuit board 3. In the third direction D3, a side on which the circuit board 3 is located is referred to as an upper side, and a side on which the board support member 5 is located is referred to as a lower side. The first surface 3a is a surface on the upper side of the circuit board 3, and the second surface 3b is a surface on the lower side of the circuit board 3.

The circuit board 3 includes a power circuit that drives the rotating electrical machine 1, a control circuit that controls the driving of the rotating electrical machine 1, a signal circuit to which signals from a sensor and the like are input, a noise filter circuit that removes noise components included in power supply and signals, and the like. Various electronic components 31 constituting the above-described circuits are mounted on the circuit board 3. The electronic components 31 are mounted on the first surface 3a and the second surface 3b of the circuit board 3.

The control circuit includes a rotation sensor 31A as the electronic component 31. The rotation sensor 31A is mounted on the second surface 3b of the circuit board 3. The rotation sensor 31A is a magnetic sensor. As shown in FIG. 1, the rotation sensor 31A is disposed coaxially with the sensor rotor 19. The sensor rotor 19 and the rotation sensor 31A face each other with a gap interposed therebetween. The rotation sensor 31A detects a change in a magnetic field from the permanent magnets of the sensor rotor 19 rotating together with the rotating shaft 11, and converts the change into an electric signal. The sensor rotor 19 and the rotation sensor 31A detect the rotation state of the rotating shaft 11. A resolver, a hall sensor, an optical sensor, or the like may be used as the rotation sensor 31A.

A plurality of terminal holes 32 are formed in the circuit board 3. The plurality of terminal holes 32 are disposed side by side at equal intervals in the first direction D1. The intervals between the plurality of terminal holes 32 may not be equal intervals.

The plurality of terminal holes 32 are disposed at an end portion on one side of the circuit board 3 in the second direction D2. The terminal holes 32 penetrate the circuit board 3 in the third direction D3. The terminal holes 32 may be distributed and disposed at a plurality of locations.

A plurality of press-fit terminals 44 of the connector 4 to be described later are press-fitted into the plurality of terminal holes 32. Conductive layers (electrical connection patterns) (not shown) to be connected to the press-fit terminals 44 are formed on inner surfaces of the terminal holes 32.

As shown in FIGS. 3A and 3B, the circuit board 3 includes a mounting portion R11, a terminal-side supported portion R12 (supported portion), and a winding-side supported portion R13.

The electronic components 31 are mounted on the mounting portion R11. The mounting portion R11 is disposed between the terminal-side supported portion R12 and the winding-side supported portion R13.

The terminal-side supported portion R12 is disposed between the mounting portion R11 and the terminal holes 32. First fastening holes 33 into which the first fastening members 6 are mounted are formed in the terminal-side supported portion R12. The first fastening holes 33 penetrate the circuit board 3 in the third direction D3. In the shown example, two first fastening holes 33 are formed side by side in the first direction D1. The number of the first fastening holes 33 may be 1 or 3 or more.

In the terminal-side supported portion R12, the second surface 3b of the circuit board 3 is in contact with a support surface 5a of the board support member 5. The terminal-side supported portion R12 is supported by the board support member 5. The terminal-side supported portion R12 is fixed to the board support member 5 by the first fastening members 6.

The winding-side supported portion R13 is disposed on a side opposite to the terminal-side supported portion R12 with the mounting portion R11 interposed therebetween. The winding-side supported portion R13 is disposed at an end portion on the other side of the circuit board 3 in the second direction D2. The winding-side supported portion R13 may be disposed inside the mounting portion R11. A second fastening hole 34 into which the second fastening member 7 is mounted is formed in the winding-side supported portion R13. The second fastening hole 34 penetrates the circuit board 3 in the third direction D3. In the shown example, one second fastening hole 34 is formed. The number of the second fastening holes 34 may be 2 or more.

**In** the winding-side supported portion R13, the second surface 3b of the circuit board 3 is in contact with the support surface 5a of the board support member 5. The winding-side supported portion R13 is supported by the board support member 5. The winding-side supported portion R13 is fixed to the board support member 5 by the second fastening member 7.

A plurality (three in the present embodiment) of winding through-holes 35 are formed in the circuit board 3. The winding through-holes 35 penetrates the circuit board 3 in the third direction D3. The three conductors of the wiring terminal 17 are respectively inserted through the winding through-holes 35. An end portion of the wiring terminal 17 is connected to the circuit board 3 by soldering or the like.

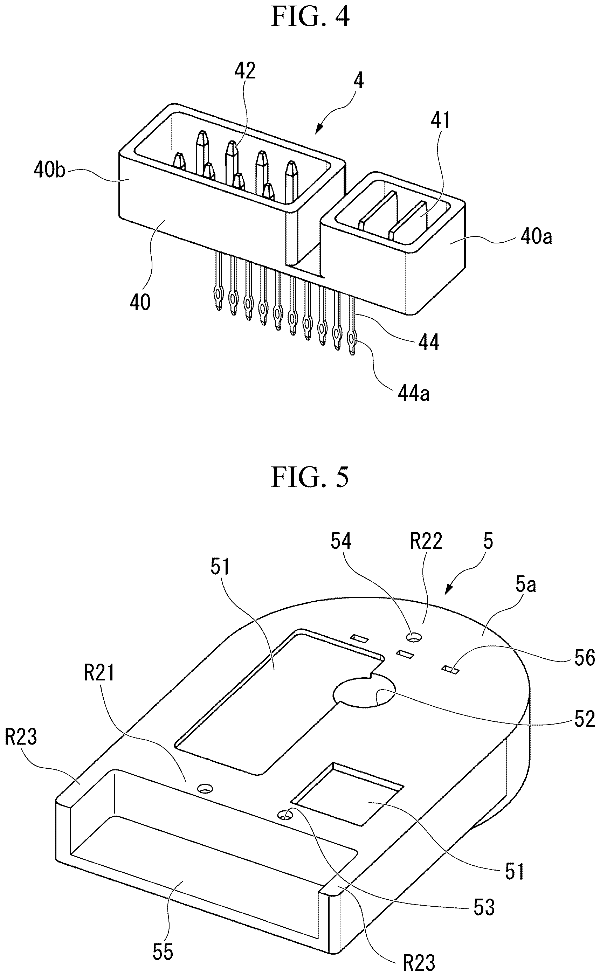

FIG. 4 is a perspective view of the connector 4. The connector 4 supplies electric power from an external power supply to the circuit board 3. The connector 4 supplies various signals from an external control device or the like to the circuit board 3. As shown in FIG. 4, the connector 4 includes a main body portion 40, power supply terminals 41, signal terminals 42, and the plurality of press-fit terminals 44 (connection terminals).

The main body portion 40 is made of resin. For example, the material of the main body portion 40 is polybutylene terephthalate (PBT) or polyphenylene sulfide (PPS). The main body portion 40 includes a power supply-side housing 40a that accommodates the power supply terminals 41 inside, and a signal-side housing 40b that accommodates the signal terminals 42 inside. In the present embodiment, the power supply-side housing 40a and the signal-side housing 40b are separate containers; however, the power supply-side housing 40a and the signal-side housing 40b may be formed of a single container. In addition, the power supply-side housing 40a and the signal-side housing 40b may be formed of three or more containers. Namely, the power supply terminals 41 and the signal terminals 42 may be accommodated in a single container or may be separately accommodated in three or more containers.

The power supply terminals 41 are connected to the external power supply. The signal terminals 42 are connected to the external control device or the like. In the present embodiment, the power supply terminals 41 and the signal terminals 42 have different shapes; however, terminals having the same shape may be used as the power supply terminals 41 and the signal terminals 42. Terminals having three or more types of shapes may be used as the power supply terminals 41 and the signal terminals 42.

The plurality of press-fit terminals 44 are provided to correspond to the power supply terminals 41 and the signal terminals 42. A plurality of the press-fit terminals 44 may be provided for one power supply terminal 41. The press-fit terminal 44 is connected to the corresponding power supply terminal 41 or the corresponding signal terminal 42. The press-fit terminals 44 extend in the third direction D3. The press-fit terminals 44 extend in a direction opposite to an extending direction of the power supply terminals 41 and the signal terminals 42. The plurality of press-fit terminals 44 are disposed side by side at equal intervals in the first direction D1. The press-fit terminals 44 may extend in a direction intersecting the extending direction of the power supply terminals 41 and the signal terminals 42 (for example, a direction orthogonal to the extending direction of the power supply terminals 41 and the signal terminals 42). The plurality of press-fit terminals 44 may be distributed and disposed at a plurality of locations.

Each of the press-fit terminals 44 is formed in an elongated plate shape as a whole. A press-fit portion 44a is formed at a distal end portion of the press-fit terminal 44. A width (maximum width) of the press-fit portion 44a is larger than a diameter of the terminal hole 32. A hole is formed in the press-fit portion 44a, and accordingly, the press-fit portion 44a can be elastically deformed. A recessed portion that allows the press-fit portion 44a to be elastically deformed may be formed in the press-fit portion 44a.

The press-fit terminals 44 are press-fitted into the terminal holes 32. At this time, the press-fit terminals 44 come into contact with the conductive layers formed on the inner surfaces of the terminal holes 32, and are electrically connected thereto. Accordingly, the connector 4 is electrically connected to the circuit board 3. By using the press-fit terminals 44, the circuit board 3 and the connector 4 can be electrically connected to each other without performing soldering or the like. Therefore, the manufacturing of the circuit connection device 2 is facilitated, and the manufacturing time can be shortened.

As shown in FIG. 1, the board support member 5 is provided between the stator 13 and the circuit board 3. The board support member 5 is fixed to the case 14. The board support member 5 covers the stator 13 from above. The board support member 5 serves as a lid that closes the inside of the rotating electrical machine 1.

The circuit board 3 is attached to the board support member 5. The board support member 5 has the support surface 5a that supports the circuit board 3. The support surface 5a is a surface on the upper side of the board support member 5. The board support member 5 is made of, for example, metal. For example, the material of the board support member 5 is aluminum or an aluminum alloy such as ADC12. The board support member 5 may be made of resin such as polybutylene terephthalate (PBT) or polyphenylene sulfide (PPS).

FIG. 5 is a perspective view of the board support member 5.

As shown in FIG. 5, first accommodating recessed portions 51 that accommodate the electronic components 31 mounted on the second surface 3b of the circuit board 3 are provided on the support surface 5a of the board support member 5. The first accommodating recessed portions 51 are provided at positions corresponding to the mounting portion R11. In the shown example, two first accommodating recessed portions 51 are formed. The number of the first accommodating recessed portions 51 may be 1 or 3 or more.

A rotating shaft through-hole 52 is formed in the board support member 5. The rotating shaft through-hole 52 penetrates the board support member 5 in the third direction D3. As shown in FIG. 1, the end portion on the non-output side of the rotating shaft 11 is inserted into the rotating shaft through-hole 52.

The board support member 5 includes a terminal-side supporting portion R21 (supporting portion) and a winding-side supporting portion R22. In the present embodiment, the support surface 5a of the board support member 5 is configured as a single surface that extends continuously from the terminal-side supporting portion R21 to the winding-side supporting portion R22 over the entire region of the board support member 5. However, the support surface 5a may be divided into a plurality of surfaces depending on the shapes of the first accommodating recessed portions 51 (namely, depending on the disposition of the electronic components 31 mounted on the second surface 3b of the circuit board 3) or the like.

The terminal-side supporting portion R21 is provided at a position corresponding to the terminal-side supported portion R12 of the circuit board 3. The terminal-side supporting portion R21 supports the terminal-side supported portion R12 from below.

Third fastening holes 53 into which the first fastening members 6 are mounted are formed in the terminal-side supporting portion R21. The third fastening holes 53 are formed at positions corresponding to the first fastening holes 33. In the shown example, two third fastening holes 53 are formed. The number of the third fastening holes 53 may be 1 or 3 or more.

The winding-side supporting portion R22 is provided at a position corresponding to the winding-side supported portion R13 of the circuit board 3. The winding-side supporting portion R22 supports the winding-side supported portion R13 from below.

A fourth fastening hole 54 into which the second fastening member 7 is mounted is formed in the winding-side supporting portion R22. The fourth fastening hole 54 is formed at a position corresponding to the second fastening hole 34. In the shown example, one fourth fastening hole 54 is formed. The number of the fourth fastening holes 54 may be 2 or more.

A second accommodating recessed portion 55 is provided on the support surface 5a of the board support member 5. The second accommodating recessed portion 55 is provided at a position corresponding to the terminal holes 32. The distal end portions of the press-fit terminals 44 press-fitted into the terminal holes 32 are accommodated in the second accommodating recessed portion 55. The second accommodating recessed portion 55 is partitioned by the terminal-side supporting portion R21 and a pair of side portions R23 extending from both ends of the terminal-side supporting portion R21 in the first direction D1 toward the one side in the second direction D2. The second accommodating recessed portion 55 is open toward the one side in the second direction D2. The pair of side portions R23 may be omitted.

A plurality (three in the present embodiment) of winding through-holes 56 are formed in the board support member 5. The winding through-holes 56 penetrate the board support member 5 in the third direction D3. The three conductors of the wiring terminal 17 are respectively inserted through the winding through-holes 56.

The first fastening members 6 are, for example, screws. The first fastening members 6 are made of metal. For example, the material of the first fastening members 6 is iron or stainless steel. The first fastening members 6 may be made of resin such as polyphenylene sulfide (PPS). The first fastening members 6 are mounted into the first fastening holes 33 and the third fastening holes 53 from the first surface 3a side of the circuit board 3. The first fastening members 6 fix the circuit board 3 to the board support member 5 in a state in which the circuit board 3 is pressed toward the board support member 5.

The second fastening member 7 is, for example, a screw. The second fastening member 7 may be made of resin. The second fastening member 7 may be made of metal. The second fastening member 7 is mounted into the second fastening hole 34 and the fourth fastening hole 54 from the first surface 3a side of the circuit board 3. The second fastening member 7 fixes the circuit board 3 to the board support member 5 in a state in which the circuit board 3 is pressed toward the board support member 5.

Next, a method for manufacturing the circuit connection device 2 according to the first embodiment will be described with reference to FIGS. 2, 6, 7A, and 7B.

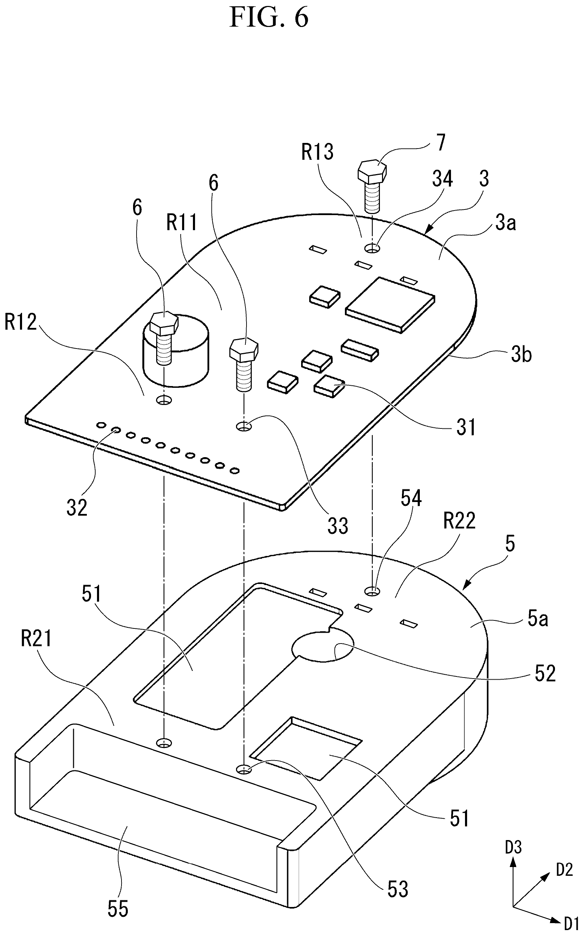

As shown in FIG. 6, first, the circuit board 3 is attached to the board support member 5. At this time, the support surface 5a of the board support member 5 and the second surface 3b of the circuit board 3 face each other. The terminal-side supported portion R12 of the circuit board 3 is placed on the terminal-side supporting portion R21 of the board support member 5. The winding-side supported portion R13 of the circuit board 3 is placed on the winding-side supporting portion R22 of the board support member 5. The electronic components 31 mounted on the second surface 3b of the circuit board 3 are accommodated in the first accommodating recessed portions 51. The circuit board 3 and the board support member 5 are fastened to each other by mounting the first fastening members 6 into the first fastening holes 33 and the third fastening holes 53 and mounting the second fastening member 7 into the second fastening hole 34 and the fourth fastening hole 54.

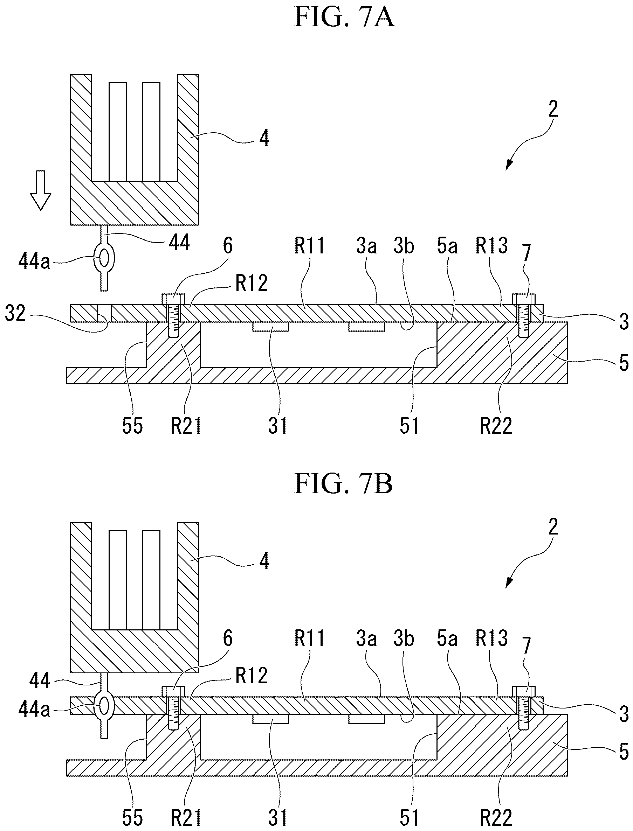

Next, the connector 4 is attached to the circuit board 3. As shown in FIG. 7A, the connector 4 is disposed on the first surface 3a side of the circuit board 3. The connector 4 is disposed such that the terminal-side supported portion R12 (namely, the first fastening members 6) and the connector 4 overlap each other when viewed in the third direction D3. As shown in FIG. 7B, the connector 4 is pressed toward the circuit board 3, and the press-fit terminals 44 are press-fitted into the terminal holes 32. Namely, in the present embodiment, the press-fit terminals 44 are press-fitted into the terminal holes 32 toward the lower side. A direction in which the press-fit terminals 44 are press-fitted is substantially the same as the third direction D3. **In** the shown example, when the press-fit terminals 44 are press-fitted into the terminal holes 32, the circuit board 3 and the connector 4 are disposed to be separated from each other. However, the circuit board 3 and the connector 4 may be disposed in proximity to or in contact with each other as long as the connector 4 may not interfere with the first fastening members 6.

Here, when the press-fit terminals 44 are press-fitted into the terminal holes 32, a pressing force is applied to the circuit board 3. In the present embodiment, the terminal-side supported portion R12 supported by the terminal-side supporting portion R21 is provided between the mounting portion R11 and the terminal holes 32. Since the pressing force applied to the circuit board 3 can be received by the terminal-side supported portion R12, the pressing force can be prevented from being directly transmitted to the mounting portion R11, and the distortion of the mounting portion R11 can be suppressed.

As described above, the circuit connection device 2 according to the present embodiment includes the connector 4 including the press-fit terminal 44 connected to the outside, the circuit board 3 on which the electronic component 31 is mounted and in which the terminal hole 32 into which the press-fit terminal 44 is press-fitted is formed, the board support member 5 that supports the circuit board 3, and the first fastening member 6 that fixes the circuit board 3 to the board support member 5. The circuit board 3 includes the mounting portion R11 on which the electronic component 31 is mounted, and the terminal-side supported portion R12 fixed to the board support member 5 by the first fastening member 6 and supported by the board support member 5. The terminal-side supported portion R12 is disposed between the mounting portion R11 and the terminal hole 32.

The circuit board 3 includes the terminal-side supported portion R12 that is disposed between the mounting portion R11 on which the electronic component 31 is mounted and the terminal hole 32, and that is supported by the board support member 5. Therefore, a pressing force applied to the circuit board 3 when the press-fit terminal 44 is press-fitted into the terminal hole 32 can be received by the terminal-side supported portion R12, and the pressing force can be prevented from being directly transmitted to the mounting portion R11. Therefore, the distortion of the circuit board 3 can be suppressed, and the electronic component 31 mounted on the mounting portion R11 can be prevented from being damaged. In addition, the electronic component 31 is mounted on the circuit board 3, and the terminal hole 32 into which the press-fit terminal 44 is press-fitted is formed in the circuit board 3. Therefore, compared to a case where a parent board on which an electronic component is mounted and a child board to which a press-fit terminal is connected are separately provided, an increase in the number of components of the circuit connection device 2 can be suppressed. As described above, according to the circuit connection device 2 of the present embodiment, it is possible to suppress the distortion of the circuit board 3 and prevent damage to the electronic component 31 mounted on the circuit board 3 while suppressing an increase in the number of components.

In addition, compared to a case where the terminal-side supported portion R12 is not provided, the electronic component 31 can be mounted at a position closer to the terminal hole 32, so that the mounting region of the electronic component 31 is expanded. Since the electronic component 31 can be efficiently mounted on the circuit board 3, the circuit board 3 can be miniaturized.

In addition, for example, in a case where the number of the press-fit terminals 44 of the connector 4 is increased for redundancy, a pressing force applied to the circuit board 3 when the press-fit terminals 44 are press-fitted into the terminal holes 32 is also increased. Even in such a case, the pressing force applied to the circuit board 3 is received by the terminal-side supported portion R12, so that the distortion of the circuit board 3 can be suppressed.

In addition, when viewed in the third direction D3, the terminal-side supported portion R12 is disposed at a position overlapping the connector 4.

Accordingly, compared to a case where the terminal-side supported portion R12 is disposed at a position not overlapping the connector 4 when viewed in the third direction D3, the position of the terminal-side supported portion R12 can be brought close to the terminal hole 32. The closer the position of the terminal-side supported portion R12 is to the terminal hole 32, the larger the effect of preventing a pressing force, which is applied to the circuit board 3 when the press-fit terminal 44 is press-fitted into the terminal hole 32, from being transmitted to the mounting portion R11 becomes. Therefore, the pressing force applied to the circuit board 3 when the press-fit terminal 44 is press-fitted into the terminal hole 32 can be more effectively prevented from being transmitted to the mounting portion R11. In addition, since the position of the mounting portion R11 can be brought close to the terminal hole 32, the electronic component 31 can be mounted at a position closer to the terminal hole 32.

### Comparative example of first embodiment.

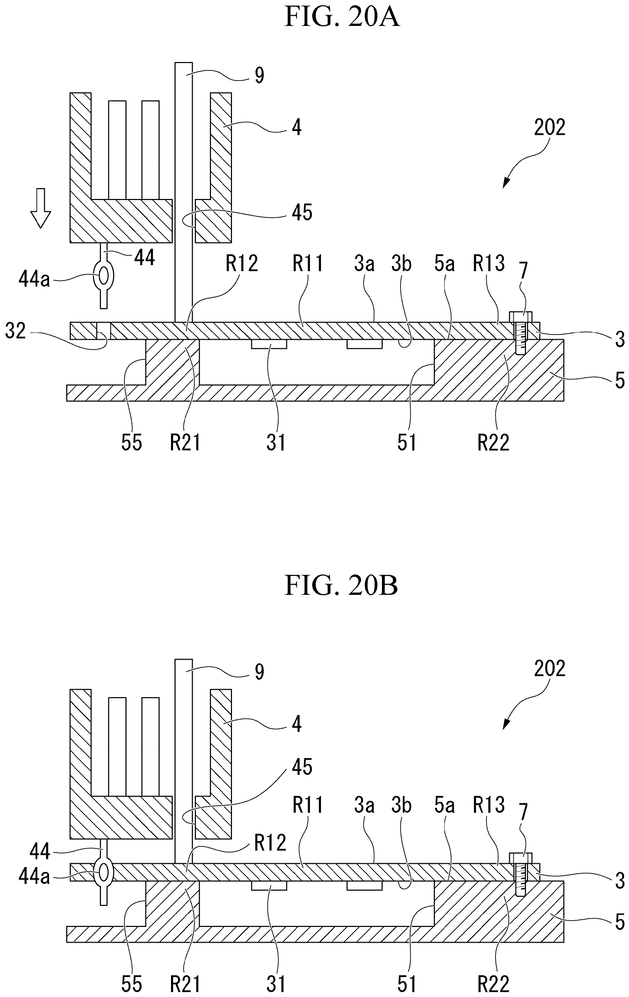

FIGS. 20A and 20B are views showing a schematic configuration of a circuit connection device 202 according to a comparative example of the first embodiment. As shown in FIGS. 20A and 20B, when the first fastening members 6 are not provided in the circuit connection device 202, it can be considered that when the connector 4 is attached to the circuit board 3, a pressing member 9 is used for pressing the circuit board 3 toward the board support member 5 to temporarily fix the circuit board 3. In this case, in a case where the terminal-side supported portion R12 is disposed at a position overlapping the connector 4 when viewed in the third direction D3, in order to avoid interference between the connector 4 and the pressing member 9, it is necessary to provide an insertion hole 45, through which the pressing member 9 is inserted, in the connector 4. Further, in order to prevent the entry of foreign matter into the circuit board 3, it is necessary to close the insertion hole 45 after the connector 4 is attached to the circuit board 3. Therefore, the manufacturing of the circuit connection device 202 becomes complicated.

In the circuit connection device 2 according to the present embodiment, the circuit board 3 is fixed to the board support member 5 using the first fastening member 6. Therefore, it is not necessary to provide the pressing member 9 or the like that is used when the connector 4 is attached to the circuit board 3, as in the circuit connection device 202 according to the comparative example, and the terminal-side supported portion R12 can be easily disposed at a position between the mounting portion R11 and the terminal hole 32 and overlapping the connector 4 when viewed in the third direction D3.

### Modification example of first embodiment

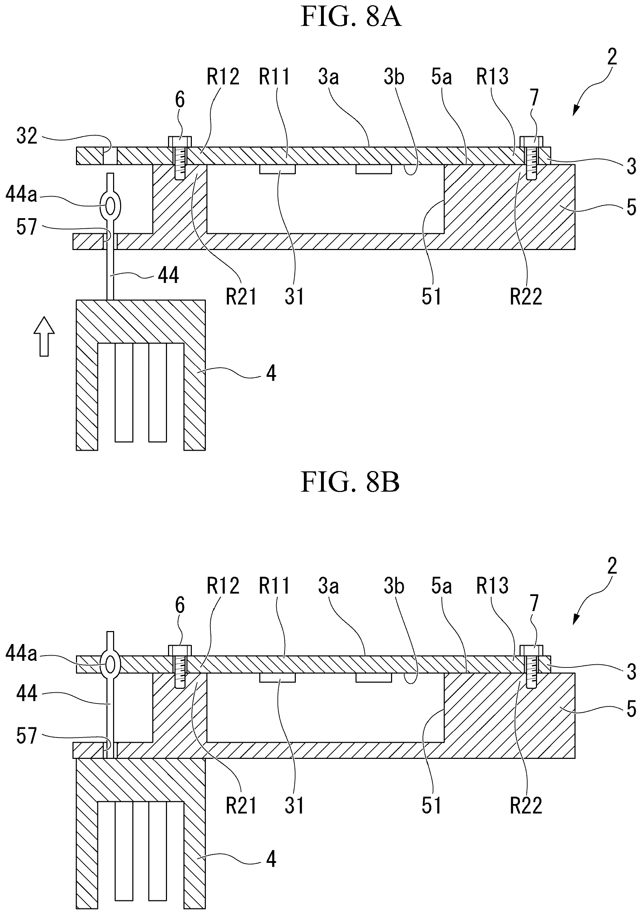

As shown in FIGS. 8A and 8B, the press-fit terminals 44 may be press-fitted into the terminal holes 32 toward the upper side. In this case, the connector 4 is disposed on the second surface 3b side of the circuit board 3. The board support member 5 is disposed between the circuit board 3 and the connector 4. Terminal through-holes 57 through which the press-fit terminals 44 are inserted are formed in the board support member 5. The press-fit terminals 44 are inserted through the terminal through-holes 57, and are press-fitted into the terminal holes 32.

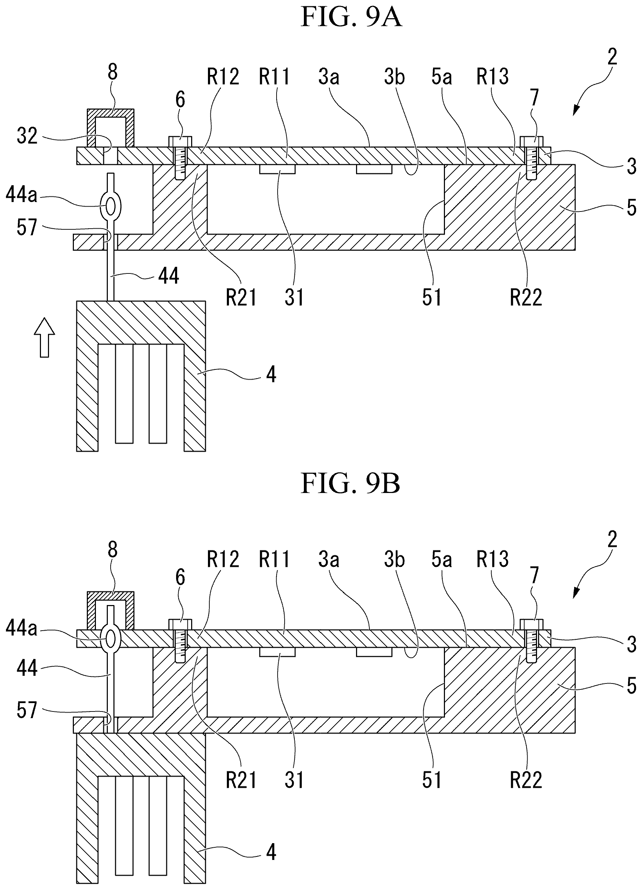

In addition, as shown in FIGS. 9 and 9B, a receiving member 8 may be provided on the first surface 3a of the circuit board 3. The receiving member 8 supports the circuit board 3 from above when the press-fit terminals 44 are press-fitted into the terminal holes 32. The receiving member 8 is provided to surround the plurality of terminal holes 32. The receiving member 8 supports both side portions of the terminal holes 32 in the second direction D2, at the circuit board 3. A pressing force applied to the circuit board 3 when the press-fit terminals 44 are press-fitted into the terminal holes 32 is received by the receiving member 8 from above, so that the distortion of the circuit board 3 can be more effectively suppressed.

The receiving member 8 may be configured to support only one side portion of the terminal holes 32 in the second direction D2, at the circuit board 3. For example, the receiving member 8 may be disposed only between the terminal holes 32 and the terminal-side supported portion R12.

### Second embodiment

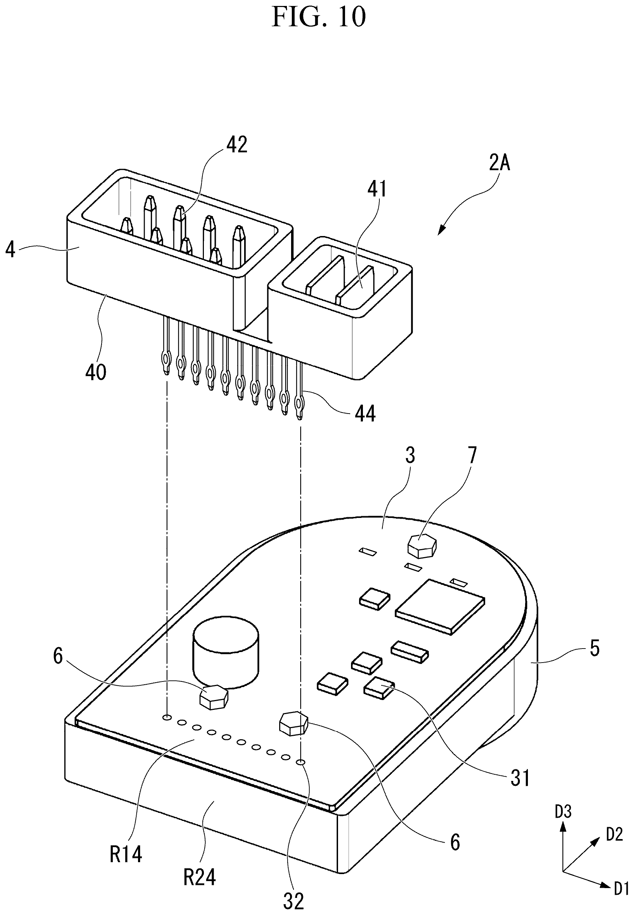

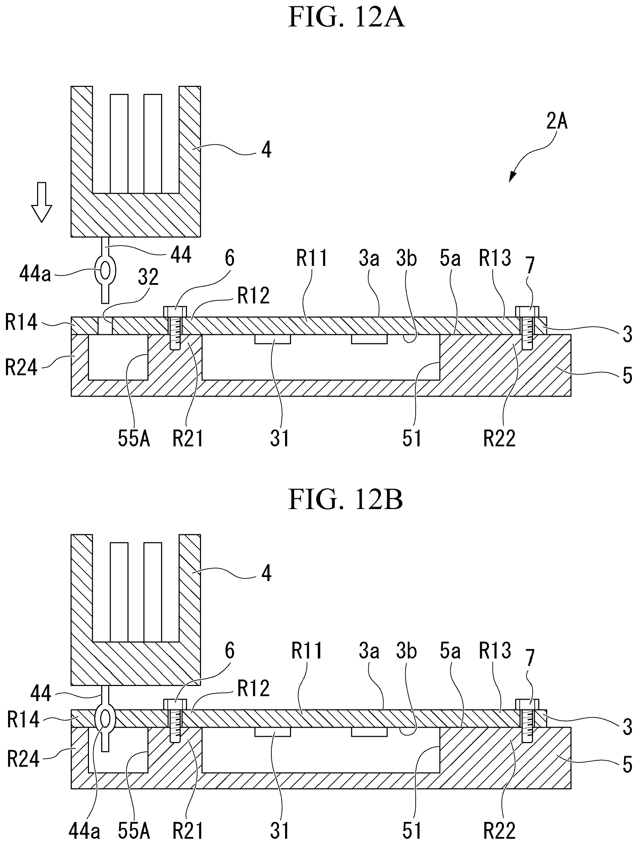

Hereinafter, a circuit connection device 2A according to a second embodiment will be described with reference to FIGS. 10 to 12B. Components having the same functions and actions as those in the first embodiment are denoted by the same reference signs, and a description thereof will be omitted.

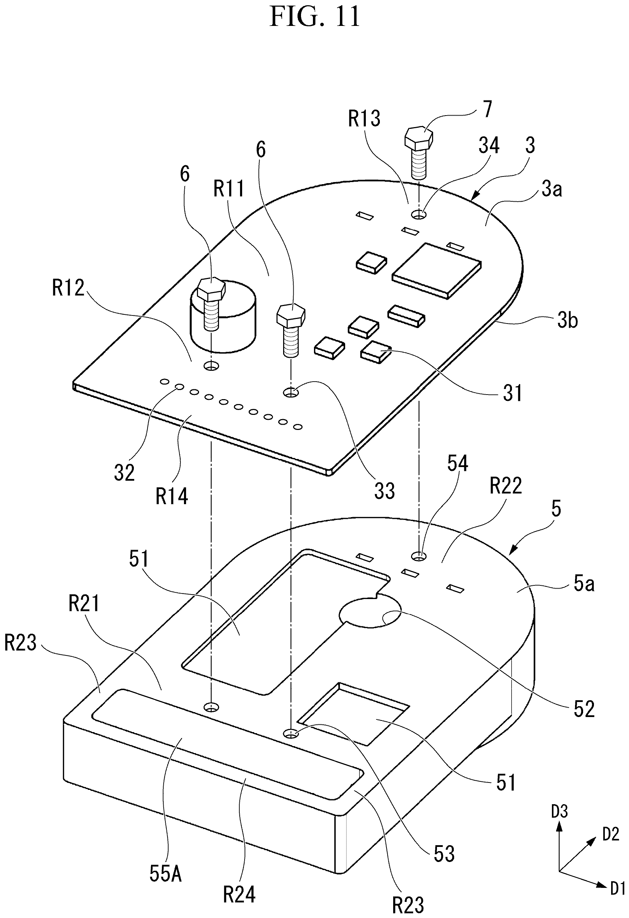

As shown in FIG. 11, in the present embodiment, the circuit board 3 further includes a second terminal-side supported portion R14 (second supported portion). The second terminal-side supported portion R14 is disposed on a side opposite to the terminal-side supported portion R12 with the plurality of terminal holes 32 interposed therebetween. Namely, the plurality of terminal holes 32 are disposed between the terminal-side supported portion R12 and the second terminal-side supported portion R14. In the second terminal-side supported portion R14, the second surface 3b of the circuit board 3 is in contact with the support surface 5a of the board support member 5. The second terminal-side supported portion R14 is supported by the board support member 5.

The board support member 5 further includes a second terminal-side supporting portion R24 (second supporting portion). The second terminal-side supporting portion R24 is provided at a position corresponding to the second terminal-side supported portion R14 of the circuit board 3. The second terminal-side supporting portion R24 supports the second terminal-side supported portion R14 from below.

In the present embodiment, the pair of side portions R23 connect both ends of the terminal-side supporting portion R21 in the first direction D1 and both ends of the second terminal-side supporting portion R24 in the first direction D1. A second accommodating recessed portion 55A (accommodating recessed portion) partitioned by the terminal-side supporting portion R21, the second terminal-side supporting portion R24, and the pair of side portions R23 is provided on the support surface 5a of the board support member 5. The second accommodating recessed portion 55A is a closed space surrounded by the terminal-side supporting portion R21, the second terminal-side supporting portion R24, and the pair of side portions R23. The distal end portions of the press-fit terminals 44 press-fitted into the terminal holes 32 are accommodated in the second accommodating recessed portion 55A. The press-fit terminals 44 are press-fitted into the terminal holes 32 toward the lower side.

In the present embodiment as well, the same effect as that of first embodiment can be achieved. Namely, according to the circuit connection device 2A of the present embodiment, it is possible to suppress the distortion of the circuit board 3 and prevent damage to the electronic components 31 mounted on the circuit board 3 while suppressing an increase in the number of components.

In addition, the circuit board 3 further includes the second terminal-side supported portion R14 supported by the board support member 5. The terminal hole 32 is disposed between the terminal-side supported portion R12 and the second terminal-side supported portion R14.

A pressing force applied to the circuit board 3 when the press-fit terminal 44 is press-fitted into the terminal hole 32 can be received by the second terminal-side supported portion R14 in addition to the terminal-side supported portion R12. Therefore, the distortion of the circuit board 3 can be more reliably suppressed.

In addition, the board support member 5 includes the terminal-side supporting portion R21 that supports the terminal-side supported portion R12, the second terminal-side supporting portion R24 that supports the second terminal-side supported portion R14, and the second accommodating recessed portion 55A that is disposed between the terminal-side supporting portion R21 and the second terminal-side supporting portion R24, and that accommodates the distal end of the press-fit terminal 44 press-fitted into the terminal hole 32. The second accommodating recessed portion 55A is surrounded by the terminal-side supporting portion R21, the second terminal-side supporting portion R24, and the pair of side portions R23 connecting the terminal-side supporting portion R21 and the second terminal-side supporting portion R24.

There is a possibility that fine metal debris may be generated when the press-fit terminal 44 is press-fitted into the terminal hole 32. Since the second accommodating recessed portion 55A is a closed space surrounded by the terminal-side supporting portion R21, the second terminal-side supporting portion R24, and the pair of side portions R23, the metal debris can be prevented from scattering to the outside of the second accommodating recessed portion 55A. Therefore, the metal debris can be prevented from adhering to various circuits and the like of the circuit board 3, such that it is possible to prevent a short circuit. In addition, foreign matter can be prevented from entering the second accommodating recessed portion 55A from the outside. Therefore, it is possible to prevent a malfunction of the circuit board 3 or the generation of an oxide on the circuit board 3 and the connector 4 due to adhesion of foreign matter from the outside to the press-fit terminal 44 or the terminal hole 32.

### Modification example of second embodiment

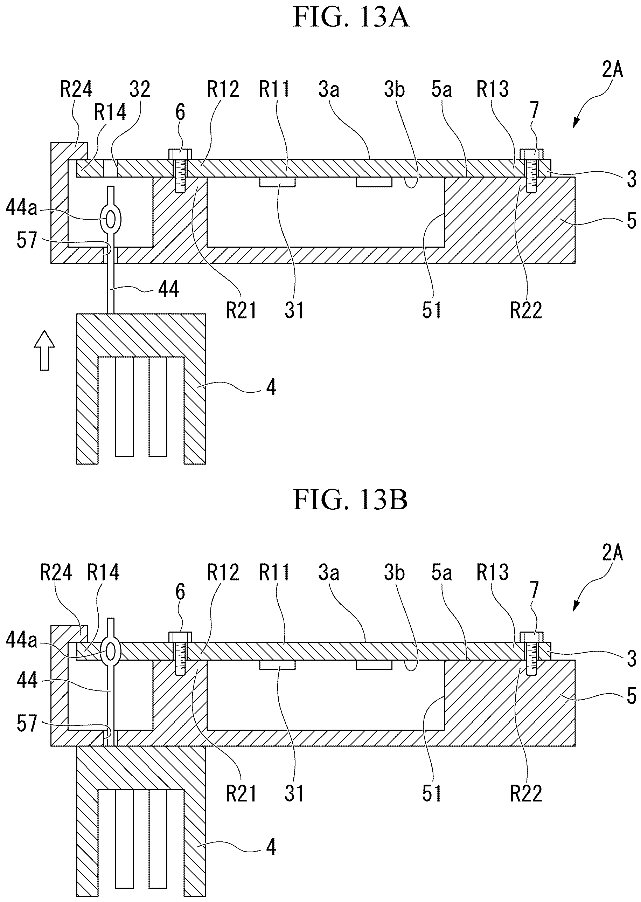

As shown in FIGS. 13A and 13B, the press-fit terminals 44 may be press-fitted into the terminal holes 32 toward the upper side. In this case, the connector 4 is disposed on the second surface 3b side of the circuit board 3. The board support member 5 is disposed between the circuit board 3 and the connector 4. The terminal through-holes 57 through which the press-fit terminals 44 are inserted are formed in the board support member 5. The press-fit terminals 44 are inserted through the terminal through-holes 57, and are press-fitted into the terminal holes 32.

In addition, the second terminal-side supporting portion R24 may come into contact with the first surface 3a of the circuit board 3 to support the second terminal-side supported portion R14 from above. In this case, a pressing force applied to the circuit board 3 when the press-fit terminals 44 are press-fitted into the terminal holes 32 can be more effectively received by the second terminal-side supporting portion R24, and the distortion of the circuit board 3 can be more effectively suppressed.

### Third embodiment

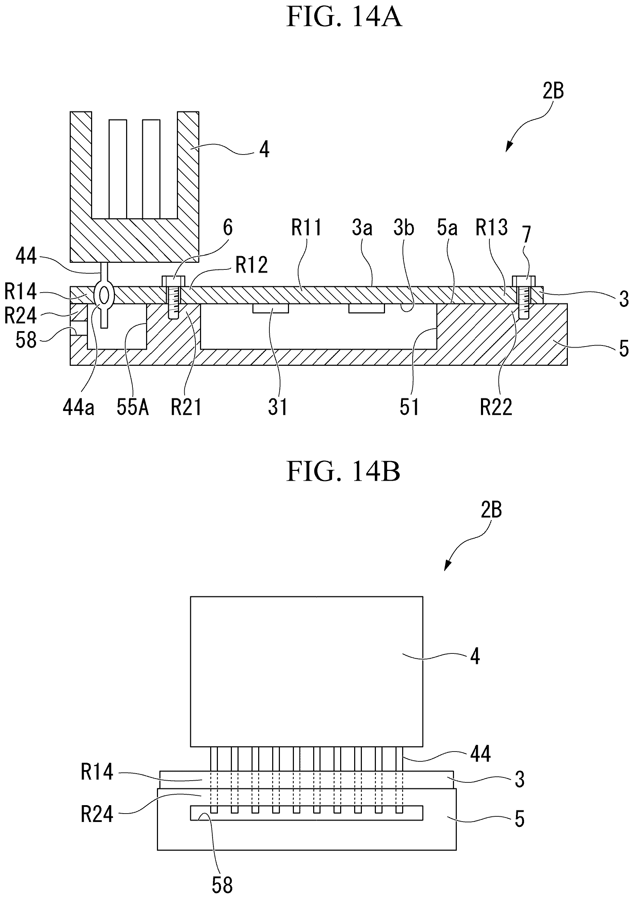

Hereinafter, a circuit connection device 2B according to a third embodiment will be described with reference to FIGS. 14A and 14B. Components having the same functions and actions as those in the first embodiment and the second embodiment are denoted by the same reference signs, and a description thereof will be omitted.

FIGS. 14A and 14B are views showing a schematic configuration of the circuit connection device 2B. FIG. 14B is a view of the circuit connection device 2B when viewed in the second direction D2.

As shown in FIG. 14A and FIG. 14B, the present embodiment is different from the second embodiment in that a viewing hole 58 is formed in the board support member 5. The viewing hole 58 is formed in the second terminal-side supporting portion R24. The viewing hole 58 is formed such that the distal ends of the press-fit terminals 44 accommodated in the second accommodating recessed portion 55A are visible from the outside. When viewed in the second direction D2, the viewing hole 58 is formed at a position overlapping the distal ends of the plurality of press-fit terminals 44. The viewing hole 58 has a size that allows all the distal ends of the plurality of press-fit terminals 44 to be visible by a single viewing hole 58.

The press-fit state of the press-fit terminals 44 into the terminal holes 32 can be confirmed through the viewing hole 58 from the outside of the circuit connection device 2B. Therefore, it is possible to prevent a connection failure between the circuit board 3 and the connector 4, a malfunction of the circuit board 3, and the like due to poor press-fitting of the press-fit terminals 44 into the terminal holes 32. For example, when the distal ends of the press-fit terminals 44 cannot be confirmed from the viewing hole 58, or when the protrusion amount of the press-fit terminals 44 visible from the viewing hole 58 is insufficient, it is determined that poor press-fitting of the press-fit terminals 44 into the terminal holes 32 has occurred.

### Modification example of third embodiment

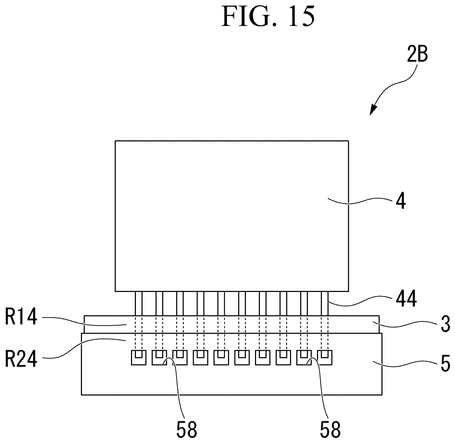

As shown in FIG. 15, a plurality of viewing holes 58 may be formed to correspond to the plurality of press-fit terminals 44. Alternatively, the plurality of viewing holes 58 may be formed such that two or more press-fit terminals 44 are visible through one viewing hole 58.

### Fourth embodiment

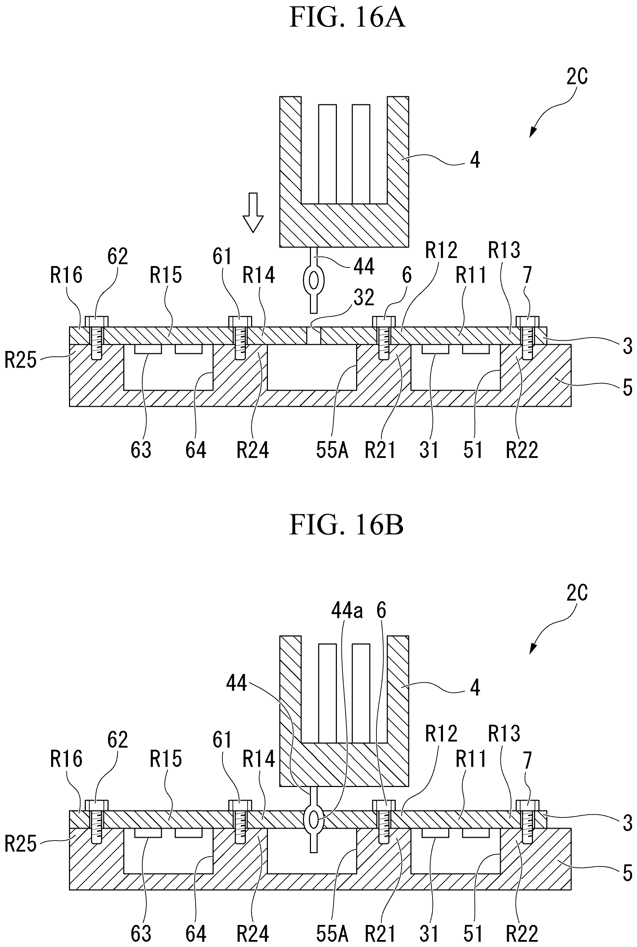

Hereinafter, a circuit connection device 2C according to a fourth embodiment will be described with reference to FIGS. 16A and 16B. Components having the same functions and actions as those in the first to third embodiments are denoted by the same reference signs, and a description thereof will be omitted.

As shown in FIGS. 16A and 16B, in the present embodiment, the circuit board 3 further includes a second mounting portion R15 and an end portion-side supported portion R16.

Second electronic components 63 are mounted on the second mounting portion R15. The second mounting portion R15 is disposed on a side opposite to the terminal holes 32 with the second terminal-side supported portion R14 interposed therebetween. Namely, the second terminal-side supported portion R14 is disposed between the second mounting portion R15 and the terminal holes 32.

The end portion-side supported portion R16 is disposed on a side opposite to the second terminal-side supported portion R14 with the second mounting portion R15 interposed therebetween. Namely, the second mounting portion R15 is disposed between the second terminal-side supported portion R14 and the end portion-side supported portion R16. In the end portion-side supported portion R16, the second surface 3b of the circuit board 3 is in contact with the support surface 5a of the board support member 5. The end portion-side supported portion R16 is supported by the board support member 5. The end portion-side supported portion R16 may be disposed inside the second mounting portion R15.

The board support member 5 further includes an end portion-side supporting portion R25. The end portion-side supporting portion R25 is provided at a position corresponding to the end portion-side supported portion R16. The end portion-side supporting portion R25 supports the end portion-side supported portion R16 from below.

A third accommodating recessed portion 64 that accommodates the second electronic components 63 mounted on the second surface 3b of the circuit board 3 is provided on the support surface 5a of the board support member 5. The third accommodating recessed portion 64 is provided at a position corresponding to the second mounting portion R15.

The second terminal-side supported portion R14 of the circuit board 3 and the second terminal-side supporting portion R24 of the board support member 5 are fastened to each other by third fastening members 61. The third fastening members 61 are, for example, screws. Fastening holes into which the third fastening members 61 are mounted are formed in the second terminal-side supported portion R14 and the second terminal-side supporting portion R24. The third fastening members 61 fix the circuit board 3 to the board support member 5 in a state where the circuit board 3 is pressed toward the board support member 5.

The end portion-side supported portion R16 of the circuit board 3 and the end portion-side supporting portion R25 of the board support member 5 are fastened to each other by fourth fastening members 62. The fourth fastening members 62 are, for example, screws. Fastening holes into which the fourth fastening members 62 are mounted are formed in the end portion-side supported portion R16 and the end portion-side supporting portion R25. The fourth fastening members 62 fix the circuit board 3 to the board support member 5 in a state where the circuit board 3 is pressed toward the board support member 5.

In the present embodiment as well, the same effect as that of first embodiment can be achieved. Namely, according to the circuit connection device 2C of the present embodiment, it is possible to suppress the distortion of the circuit board 3 and prevent damage to the electronic components 31 mounted on the circuit board 3 while suppressing an increase in the number of components.

In addition, the circuit board 3 further includes the second mounting portion R15 on which the second electronic component 63 is mounted. The second terminal-side supported portion R14 is disposed between the second mounting portion R15 and the terminal hole 32.

The mounting regions of the electronic components 31 and 63 can be expanded by providing the second mounting portion R15. In addition, the second terminal-side supported portion R14 supported by the board support member 5 is disposed between the second mounting portion R15 and the terminal hole 32. Therefore, a pressing force applied to the circuit board 3 when the press-fit terminal 44 is press-fitted into the terminal hole 32 can be received by the second terminal-side supported portion R14, and the pressing force can be prevented from being directly transmitted to the second mounting portion R15. Therefore, the distortion of the circuit board 3 can be suppressed, and the second electronic component 63 mounted on the second mounting portion R15 can be prevented from being damaged.

### Fifth embodiment

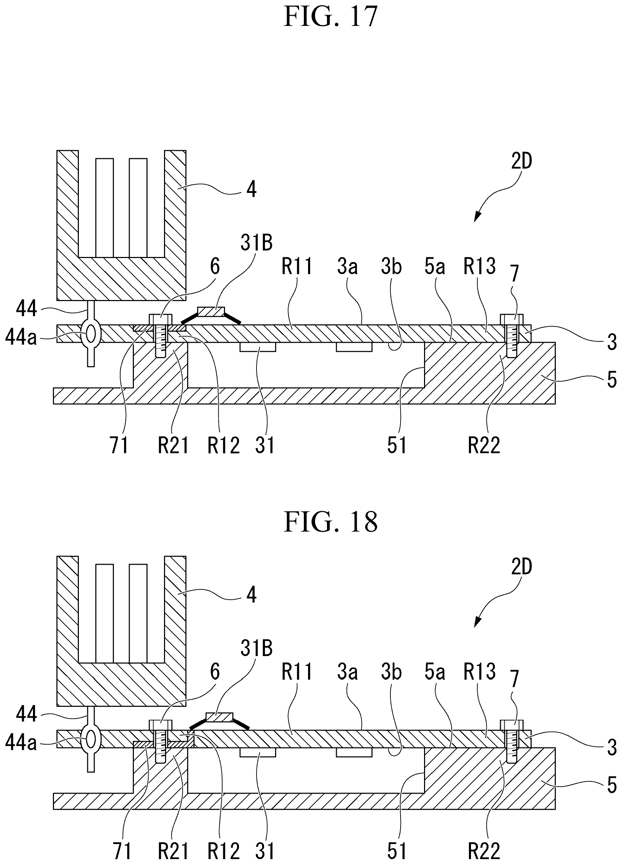

Hereinafter, a circuit connection device 2D according to a fifth embodiment will be described with reference to FIG. 17. Components having the same functions and actions as those in the first to fourth embodiments are denoted by the same reference signs, and a description thereof will be omitted.

In the present embodiment, the board support member 5 and the first fastening members 6 are made of metal. In addition, as shown in FIG. 17, a noise suppression component 31B as the electronic component 31 is mounted on the first surface 3a of the circuit board 3. The noise suppression component 31B includes an X capacitor and a Y capacitor. The noise suppression component 31B is disposed in proximity to the terminal-side supported portion R12 of the circuit board 3.

A GND pattern 71 (electrical connection portion) is provided on the terminal-side supported portion R12. The GND pattern 71 is disposed on the first surface 3a of the circuit board 3. The X capacitor and the Y capacitor of the noise suppression component 31B are electrically connected to the GND pattern 71. When the first fastening member 6 is fastened to the circuit board 3, the first fastening member 6 comes into contact with the GND pattern 71, and the GND pattern 71 and the first fastening member 6 are electrically connected to each other.

The board support member 5 is electrically connected to a ground (GND). When the first fastening members 6 are fastened to the board support member 5, the first fastening members 6 come into contact with the board support member 5, and the first fastening members 6 and the board support member 5 are electrically connected to each other. Therefore, the X capacitor and the Y capacitor of the noise suppression component 31B are connected to the GND via the GND pattern 71, the first fastening member 6, and the board support member 5.

In the present embodiment as well, the same effect as that of first embodiment can be achieved. Namely, according to the circuit connection device 2D of the present embodiment, it is possible to suppress the distortion of the circuit board 3 and prevent damage to the electronic component 31 mounted on the circuit board 3 while suppressing an increase in the number of components.

In addition, the board support member 5 is made of metal, and is electrically connected to the GND. The first fastening member 6 is made of metal, and is electrically connected to the board support member 5. The GND pattern 71 that electrically connects the noise suppression component 31B as the electronic component 31 and the first fastening member 6 is formed on the terminal-side supported portion R12.

Accordingly, the noise suppression component 31B can be connected to the GND via the board support member 5 and the first fastening member 6.

In addition, when the noise suppression component 31B is disposed at a position close to the terminal-side supported portion R12 (namely, a position close to the terminal hole 32) on the mounting portion R11, the noise suppression component 31B can effectively remove noise of power supply and signals. For example, when power is supplied from the press-fit terminal 44 to the electronic component 31 via the terminal hole 32, the noise suppression component 31B can remove noise of the power supply immediately after being input to the mounting portion R11. When signals are output from the electronic component 31 to the press-fit terminal 44 via the terminal hole 32, the noise suppression component 31B can remove noise of the signals immediately before the terminal hole 32.

In addition, since the distortion of the mounting portion R11 can be suppressed by the terminal-side supported portion R12, a ceramic capacitor or the like having small distortion resistance but being small in size can be used as the noise suppression component 31B. Therefore, the circuit board 3 can be miniaturized.

### Modification example of fifth embodiment

As shown in FIG. 18, the GND pattern 71 may be formed to extend to the second surface 3b of the circuit board 3 in the terminal-side supported portion R12. In this case, the GND pattern 71 is directly connected to the board support member 5. The X capacitor and the Y capacitor of the noise suppression component 31B are connected to the GND via the GND pattern 71 and the board support member 5.

### Sixth embodiment

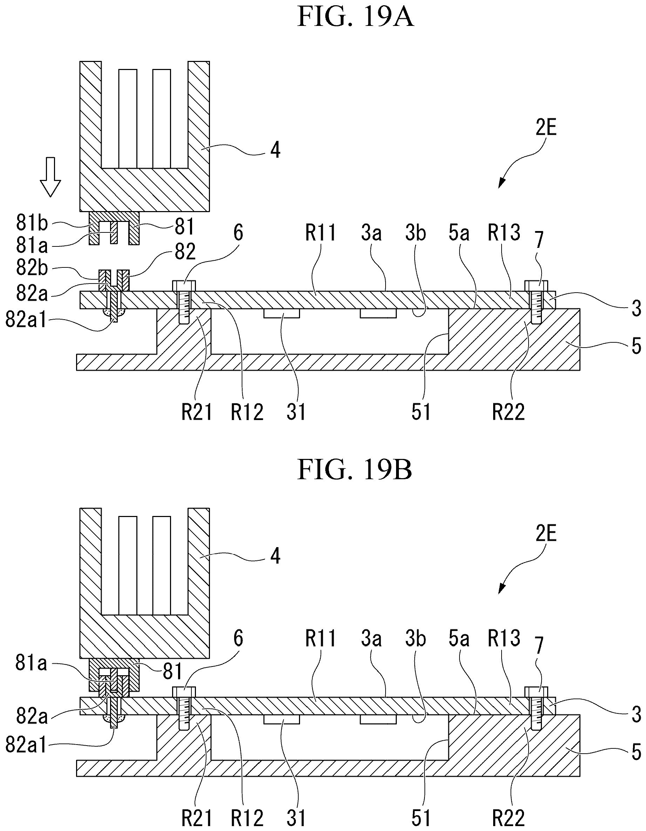

Hereinafter, a circuit connection device 2E according to a sixth embodiment will be described with reference to FIGS. 19A and 19B. Components having the same functions and actions as those in the first to fifth embodiments are denoted by the same reference signs, and a description thereof will be omitted.

As shown in FIGS. 19A and 19B, in the present embodiment, the circuit board 3 and the connector 4 are connected to each other using a multipole connector.

The connector 4 includes a recessed connector component 81 instead of the plurality of press-fit terminals 44. The recessed connector component 81 includes a plurality of connection terminals 81a disposed side by side in the first direction D1, and a holding member 81b that holds the plurality of connection terminals 81a. The holding member 81b includes a recessed portion, and the plurality of connection terminals 81a are disposed inside the recessed portion.

The circuit board 3 includes a protruding connector component 82. The protruding connector component 82 includes a plurality of connection fit portions 82a (terminal holes) disposed side by side in the first direction D1, and a holding member 82b that holds the plurality of connection fit portions 82a. One end portions of the plurality of connection fit portions 82a are fitted to the plurality of connection terminals 81a. The other end portions 82a1 of the plurality of connection fit portions 82a are fixed to the circuit board 3, for example, by soldering.

The circuit board 3 and the connector 4 are electrically connected to each other by respectively fitting the plurality of connection terminals 81a into the one end portions of the plurality of connection fit portions 82a. When the connection terminals 81a are fitted into the one end portions of the connection fit portions 82a, a pressing force is applied to the circuit board 3. The terminal-side supported portion R12 supported by the board support member 5 is disposed between the mounting portion R11 on which the electronic components 31 are mounted and the terminal holes 32. Therefore, the pressing force applied to the circuit board 3 when the connection terminals 81a are fitted to the one end portions of the connection fit portions 82a can be received by the terminal-side supported portion R12, and the pressing force can be prevented from being directly transmitted to the mounting portion R11. Therefore, the distortion of the circuit board 3 can be suppressed, and the electronic components 31 mounted on the mounting portion R11 can be prevented from being damaged. In addition, the electronic components 31 are mounted on the circuit board 3, and the connection fit portions 82a into which the connection terminals 81a are press-fitted are formed on the circuit board 3. Therefore, compared to a case where a parent board on which electronic components are mounted and a child board to which connection terminals are connected are separately provided, an increase in the number of components of the circuit connection device 2E can be suppressed. As described above, according to the circuit connection device 2E of the present embodiment, it is possible to suppress the distortion of the circuit board 3 and prevent damage to the electronic components 31 mounted on the circuit board 3 while suppressing an increase in the number of components.

The embodiments can be combined, and each embodiment can be modified or omitted as appropriate.

For example, the numbers of the press-fit terminals 44, the first fastening members 6, the second fastening members 7, and the like are appropriately changed according to the specifications of the rotating electrical machine device 100.

The first fastening member 6 and the second fastening member 7 are not limited to screws as long as they are able to fix the circuit board 3 to the board support member 5.

The board support member 5 may be integrally formed with the case 14 of the rotating electrical machine 1.

The plurality of terminal holes 32 may be disposed at an end portion on one side in the first direction D1. In this case, for example, the mounting portion R11 may be disposed at an end portion on the other side in the first direction D1, and the terminal-side supported portion R12 may be disposed to be interposed between the mounting portion R11 and the terminal holes 32 in the first direction D1. The plurality of terminal holes 32 may be disposed in combination at the end portion on the one side in the first direction D1 and the end portion on the one side in the second direction D2.

### [Reference Signs List]

1: Rotating electrical machine
2, 2A, 2B, 2C, 2D, 2E: Circuit connection device
3: Circuit board
4: Connector
5: Board support member
6: First fastening member (fixing member)
31: Electronic component
31B: Noise suppression component
32: Terminal hole
44: Press-fit terminal (connection terminal)
55A: Second accommodating recessed portion (accommodating recessed portion)
58: Viewing hole
63: Second electronic component
71: GND pattern (electrical connection portion)
81a: Connection terminal
82a: Connection fit portion (terminal hole)
R11: Mounting portion
R12: Terminal-side supported portion (supported portion)
R14: Second terminal-side supported portion (second supported portion)
R15: Second mounting portion
R21: Terminal-side supporting portion (supporting portion)
R23: Side portion
R24: Second terminal-side supporting portion (second supporting portion)
100: Rotating electrical machine device

## Claims

1. A circuit connection device comprising:
a connector including a connection terminal connected to an outside;
a circuit board on which an electronic component is mounted and in which a terminal hole into which the connection terminal is press-fitted is formed;
a board support member that supports the circuit board; and
a fixing member that fixes the circuit board to the board support member,
wherein the circuit board includes a mounting portion on which the electronic component is mounted, and a supported portion fixed to the board support member by the fixing member and supported by the board support member, and
the supported portion is disposed between the mounting portion and the terminal hole.

2. The circuit connection device according to Claim 1,
wherein the circuit board further includes a second supported portion supported by the board support member, and
the terminal hole is disposed between the supported portion and the second supported portion.

3. The circuit connection device according to Claim 2,
wherein the board support member includes:
a supporting portion that supports the supported portion of the circuit board;
a second supporting portion that supports the second supported portion of the circuit board; and
an accommodating recessed portion that is disposed between the supporting portion and the second supporting portion and that accommodates a distal end of the connection terminal press-fitted into the terminal hole, and
the accommodating recessed portion is surrounded by the supporting portion, the second supporting portion, and a pair of side portions connecting the supporting portion and the second supporting portion.

4. The circuit connection device according to Claim 3,
wherein a viewing hole through which the distal end of the connection terminal accommodated in the accommodating recessed portion is visible from the outside is formed in the board support member.

5. The circuit connection device according to any one of Claims 2 to 4,
wherein the circuit board further includes a second mounting portion on which a second electronic component is mounted, and
the second supported portion is disposed between the second mounting portion and the terminal hole.

6. The circuit connection device according to any one of Claims 1 to 5,
wherein in a case where a side on which the board support member is located when viewed from the circuit board is defined as a lower side, the connection terminal is press-fitted into the terminal hole toward the lower side.

7. The circuit connection device according to any one of Claims 1 to 5,
wherein in a case where a side on which the circuit board is located when viewed from the board support member is defined as an upper side, the connection terminal is press-fitted into the terminal hole toward the upper side.

8. The circuit connection device according to any one of Claims 1 to 7,
wherein the board support member is made of metal, and is electrically connected to a GND,
the fixing member is made of metal, and is electrically connected to the board support member, and
an electrical connection portion that electrically connects a noise suppression component as the electronic component and the fixing member is formed on the supported portion.

9. The circuit connection device according to any one of Claims 1 to 8,
wherein the supported portion is disposed at a position overlapping the connector when viewed in a thickness direction of the circuit board.

10. A rotating electrical machine device comprising:
a rotating electrical machine; and
the circuit connection device according to any one of Claims 1 to 9 configured to control the rotating electrical machine.
